# FASCICULE DE BREVET EUROPEEN

(11) **EP 3 197 035 B1**
(45) Date de publication et mention de la délivrance du brevet: **26.05.2021**
(21) Numéro de dépôt: 17151678.4
(22) Date de dépôt: 16.01.2017
(51) Int. Cl.: H02M 7/00, H05K 7/20, H05K 7/14

(54) **EQUIPEMENT ELECTRIQUE, NOTAMMENT POUR VEHICULE AUTOMOBILE**
ELEKTRISCHE AUSSTATTUNG, INSBESONDERE FÜR KRAFTFAHRZEUG
ELECTRICAL SYSTEM, IN PARTICULAR FOR A MOTOR VEHICLE

(30) Priorité: 20.01.2016 FR 1650454
(43) Date de publication de la demande: 26.07.2017
(73) Titulaire: Valeo Systemes de Controle Moteur, 95800 Cergy Saint Christophe (FR)
(72) Inventeur: DENIOT, Roger, 78300 Poissy (FR)
(74) Mandataire: Novembre, Christophe Adelphe

(56) Documents cités:
- EP-A1- 1 455 561
- US-A1- 2010 259 898

## Description

La présente invention concerne un équipement électrique, notamment pour véhicule automobile.

On connait par le brevet US 8 462 531 un onduleur de puissance avec des passages de refroidissement.

On connait également par le document US 2010/259898 A1 un convertisseur de puissance comprenant un dispositif de refroidissement d'une pluralité de capacité.

L'invention vise à proposer un équipement électrique amélioré, notamment avec une capacité mieux refroidie.

L'invention a ainsi pour objet un équipement électrique, notamment pour véhicule automobile, cet équipement comportant :
- au moins deux composants électriques de puissance, notamment connectés électriquement en parallèle,
- au moins deux conducteurs électriques chacun connectés à l'un des composants électriques de puissance, les deux conducteurs comportant chacun au moins une portion d'échange thermique,
- un dispositif de refroidissement agencé pour refroidir les conducteurs électriques via les portions d'échange thermique, équipement dans lequel les portions d'échange thermique des conducteurs sont coplanaires, ledit équipement étant caractérisé en ce que:
   - l'un au moins des conducteurs électriques, comporte, outre la portion d'échange thermique avec l'un des composants électrique de puissance, une portion de contact électrique (18 ;19) avec l'autre des composants électriques de puissance, cette portion de contact étant de préférence éloignée du dispositif de refroidissement,
   - la portion de contact (18, 19) de l'un des conducteurs est sur un côté du composant électrique et la portion d'échange thermique (6, 7) de l'autre des conducteurs est sur un côté opposé de ce composant électrique, et
   - l'un au moins des conducteurs comporte un bras (20) reliant la portion d'échange thermique à la portion de contact, ce bras étant de préférence sensiblement perpendiculaire à la portion d'échange thermique.

Grâce à l'invention, il est possible d'avoir un équipement électrique mieux refroidi. En effet les conducteurs, par exemple l'un positif et l'autre négatif, étant dans le même plan, sont refroidis en même temps et de manière uniforme.

De préférence les portions d'échange thermique des conducteurs sont en contact thermique, direct ou indirect, avec le dispositif Description amendée avec marques de révision de refroidissement, notamment via un conducteur thermique isolant électrique placé sur le dispositif de refroidissement.

Si on le souhaite, les portions d'échange thermique des deux conducteurs présentent des superficies sensiblement identiques.

Par exemple, l'un au moins des conducteur est en cuivre ou en aluminium. Par exemple, l'un au moins des conducteur est un busbar.

Les portions d'échange thermique des deux conducteurs présentent par exemple des épaisseurs sensiblement identiques.

Notamment, l'une des portions d'échange thermique est connectée à une borne du composant électrique de puissance et l'autre des portions d'échange thermique est connectée à une borne de l'autre composant électrique de puissance, lesdites bornes ayant des polarités opposées l'une par rapport à l'autre.

Notamment l'une des portions d'échange thermique est connectée à une borne positive du composant électrique de puissance et l'autre des portions d'échange thermique est connectée à une borne négative de l'autre composant électrique de puissance.

L'un au moins des conducteurs électriques est notamment connecté à des bornes de même polarité des deux composants électriques de puissance.

L'un au moins des conducteurs électriques est notamment connecté à des bornes positives des deux composants électriques de puissance.

Selon l'invention l'un au moins des conducteurs électriques, connecté avec l'un des composants électriques de puissance, comporte, outre la portion d'échange thermique, une portion de contact électrique avec l'autre des composants électriques de puissance, cette portion de contact étant notamment éloignée du dispositif de refroidissement.

Selon l'invention l'un au moins des conducteurs électriques, comporte, outre la portion d'échange thermique avec l'un des composants électrique de puissance, une portion de contact électrique avec l'autre des Description amendée avec marques de révision composants électriques de puissance, cette portion de contact étant notamment éloignée du dispositif de refroidissement.

Notamment la portion de contact de l'un des conducteurs est sensiblement parallèle à la portion d'échange thermique de l'autre des conducteurs électriques.

Par exemple la portion de contact de l'un des conducteurs est sensiblement plane.

Selon l'invention la portion de contact de l'un des conducteurs est sur un côté du composant électrique et la portion d'échange thermique de l'autre des conducteurs est sur un côté opposé de ce composant électrique.

Notamment les portions de contact, de préférence éloignées du dispositif de refroidissement, sont sensiblement coplanaires.

Selon l'invention l'un au moins des conducteurs comporte un bras reliant la portion d'échange thermique à la portion de contact, ce bras étant de préférence sensiblement perpendiculaire à la portion d'échange thermique.

De préférence, le bras est disposé entre les deux composants électriques de puissance, ce bras notamment longe une face de l'un des composants électriques de puissance.

De préférence les deux conducteurs comportent chacun un bras, les bras de ces deux conducteurs étant sensiblement coplanaires. Ceci permet une meilleure compacité.

Notamment les deux conducteurs sont isolés électriquement l'un de l'autre, par exemple par une lame d'air, un isolant électrique avec notamment une garniture, un papier.

Par exemple les portions d'échange thermique présentent au moins un bord droit, les bords droits des portions étant alignés.

Le cas échéant les portions d'échange thermique présentent une forme sensiblement rectangulaire.

Description amendée avec marques de révision

L'un au moins des conducteurs, de préférence les deux conducteurs, est notamment connecté à un module de puissance via des pattes de connexion, par exemple pour convertir une énergie électrique.

Les pattes de connexion des deux conducteurs sont disposées de manière alternée entre elles par exemple.

Par exemple, les conducteurs sont réalisés par découpe et pliage d'une plaque. Les conducteurs sont notamment à base d'aluminium ou de cuivre. Les conducteurs sont encore appelés *Busbar* en anglais.

Les pattes présentent chacun un coude si on le souhaite.

Par exemple les pattes se raccordent à un rebord commun du conducteur.

Si on le souhaite l'un au moins des composants électriques de puissance comporte au moins une unité de stockage d'énergie électrique, notamment un condensateur, notamment une pluralité d'unités, notamment de condensateurs, par exemple trois condensateurs. Par exemple chaque composant comprend un groupe de trois condensateurs.

Le dispositif de refroidissement comporte notamment une paroi d'échange thermique contre laquelle sont posées les portions d'échange thermique des conducteurs, cette paroi étant de préférence sensiblement plane.

De préférence le dispositif de refroidissement comporte un canal de circulation d'un fluide de refroidissement, par exemple de l'eau ou du glycol. La paroi d'échange thermique est notamment en contact avec le canal de refroidissement.

La paroi d'échange thermique est réalisée en aluminium par exemple.

L'équipement comporte notamment un module de puissance en contact thermique avec le dispositif de refroidissement.

De préférence le module de puissance comporte une pluralité de pattes de connexion électriques agencées pour la connexion électrique du module de puissance avec les composants électriques de puissance.

Avantageusement les conducteurs sont agencés de sorte qu'ils sont refroidis par le dispositif de refroidissement avant la sortie électrique du module de puissance.

Par exemple l'équipement est agencé en module de puissance, par exemple en onduleur notamment continu/alternatif.

L'onduleur est par exemple agencé pour opérer à une puissance supérieure à 50 kW, notamment 100 kW, opérant notamment à une puissance électrique de 140 kW.

Le dispositif de refroidissement est notamment éloigné d'un couvercle de l'équipement.

L'invention sera mieux comprise et d'autres détails, caractéristiques et avantages de l'invention apparaîtront à la lecture de la description suivante faite à titre d'exemple non limitatif en référence au dessin annexé dans lequel :

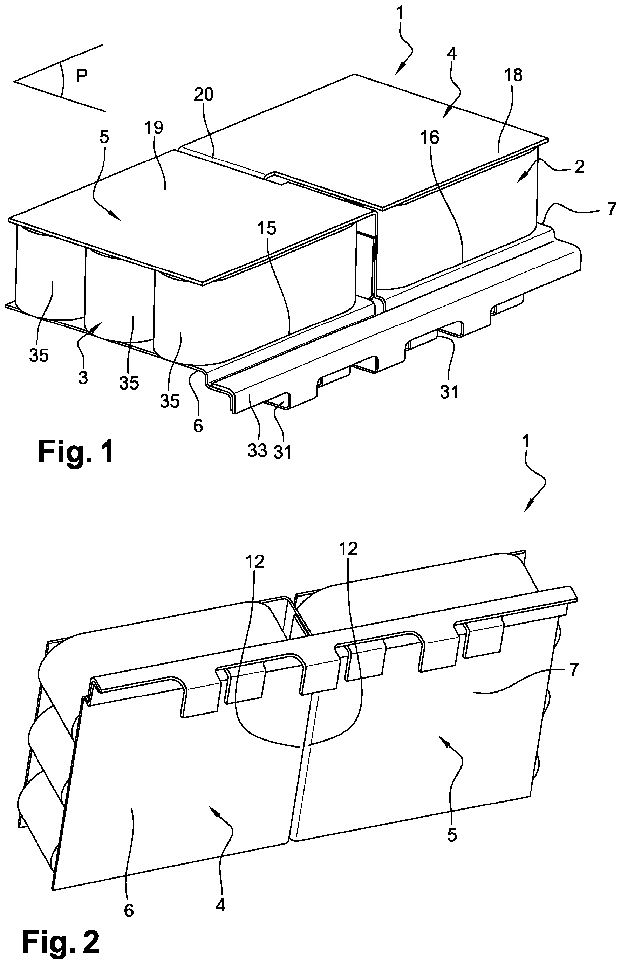

- les figures 1 à 3 représentent, schématiquement et partiellement, respectivement en perspective et en coupe, un équipement électrique selon un exemple de réalisation de l'invention.

On a représenté sur les figures 1 à 3 un équipement électrique 1 pour véhicule automobile, ce dispositif comportant :
- deux composants électriques de puissance 2 et 3 connectés électriquement en parallèle,
- deux conducteurs électriques 4 et 5 comportant chacun une portion d'échange thermique 6 et 7 respectivement,
- un dispositif de refroidissement 10 agencé pour refroidir les conducteurs électriques 4 et 5 via les portions d'échange thermique 6 et 7.

Les portions d'échange thermique 6 et 7 des conducteurs sont coplanaires dans un plan P.

Dans l'exemple décrit, l'équipement 1 est agencé en onduleur pour convertir du courant continu en alternatif.

L'onduleur est par exemple agencé pour opérer à une puissance supérieure à 50 kW, notamment 100 kW, opérant notamment à une puissance électrique de 140 kW.

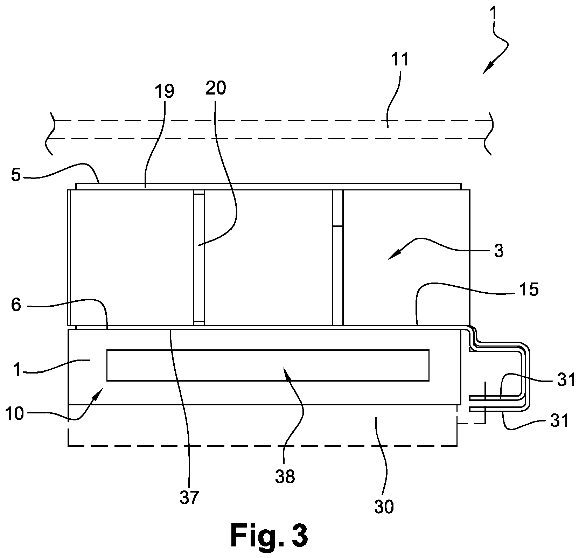

Le dispositif de refroidissement 10 est notamment éloigné d'un couvercle 11 de l'équipement, comme on peut le voir sur la figure 3. Ce couvercle 11 permet de protéger l'intérieur de l'équipement d'infiltrations extérieures, par exemple de la poussière ou de liquides indésirables.

Les portions d'échange thermique 6 et 7 des conducteurs sont en contact thermique avec le dispositif de refroidissement 10 via un conducteur thermique isolant électrique.

Ces portions d'échange thermique 6 et 7 des deux conducteurs présentent des superficies sensiblement identiques, et des épaisseurs sensiblement identiques.

Les portions d'échange thermique 6 et 7 présentent chacun une forme sensiblement rectangulaire et sont disposées à bords parallèles 12, côte à côte.

Les conducteurs 4 et 5 sont réalisés chacun d'une seule pièce.

L'une des portions d'échange thermique 6 est connectée électriquement à une borne positive 15 du composant électrique de puissance 3 et l'autre des portions d'échange thermique 7 est connectée à une borne négative 16 de l'autre composant électrique de puissance 2.

Chaque conducteur électrique 4 ;5 est connecté à des bornes positives ou négatives des deux composants électriques de puissance.

Chaque conducteur électrique 4 ;5 comporte, outre la portion d'échange thermique, une portion de contact électrique 18 ;19 avec l'autre des composants électriques de puissance, cette portion de contact 18 ;19 étant éloignée du dispositif de refroidissement 10.

La portion de contact 18 ;19 de l'un des conducteurs est sensiblement parallèle à la portion d'échange thermique 7 ;6 de l'autre des conducteurs électriques.

Les portions de contact 18 ;19 sont sensiblement planes.

La portion de contact 18 ;19 de l'un des conducteurs est sur un côté du composant électrique 2 ;3 et la portion d'échange thermique 7 ;6 de l'autre des conducteurs est sur un côté opposé de ce composant électrique de sorte que le composant soit entre la portion de contact 19 ;18 et la portion d'échange thermique 6 ;7.

Les portions de contact 18 et 19, éloignées du dispositif de refroidissement 10, sont sensiblement coplanaires.

Chaque conducteur 4 ;5 comporte un bras 20 reliant la portion d'échange thermique 6 ;7 à la portion de contact 18 ;19, ce bras étant sensiblement perpendiculaire à la portion d'échange thermique 6 ;7.

Autrement dit chaque conducteur 4 ;5 comporte une portion d'échange thermique et une portion de contact reliées entre elles par le bras 20.

Le bras 20 est disposé entre les deux composants électriques de puissance 2 et 3, et ce bras 20 longe, sans toucher, une face des composants électriques de puissance.

Les bras 20 de ces deux conducteurs sont sensiblement coplanaires. Ceci permet une meilleure compacité.

Les deux conducteurs 4 et 5 sont isolés électriquement l'un de l'autre.

Comme visible sur la figure 3, les deux conducteurs 4 et 5 sont connectés à un module de puissance 30 via des pattes de connexion 31.

Les pattes de connexion 31 coudées des deux conducteurs sont disposées de manière alternée entre elles.

Les conducteurs 4 et 5 sont réalisés par découpe et pliage d'une plaque, par exemple en cuivre ou aluminium. Les conducteurs sont encore appelés *Busbaren* anglais.

Les pattes 31 se raccordent à un rebord 33 commun du conducteur 4 ;5 correspondant. Ce rebord 33 est sensiblement parallèle à un côté des composants 2 et 3.

Chaque composant électrique de puissance 2 ;3 comporte des unités de stockage d'énergie électrique 35, à savoir dans l'exemple décrit trois condensateurs. Au total, dans l'exemple, l'onduleur comporte six condensateurs. Bien entendu, l'invention n'est pas limitée à ce nombre.

Le dispositif de refroidissement 10 comporte une paroi d'échange thermique 37 contre laquelle sont posées les portions d'échange thermique 6 et 7 des conducteurs, cette paroi 37 étant sensiblement plane, comme visible sur la figure 3.

Le dispositif de refroidissement 10 comporte un canal de circulation 38 d'un fluide de refroidissement, par exemple de l'eau. La paroi d'échange thermique 37 est en contact avec le canal de refroidissement 10.

La paroi d'échange thermique 37 est réalisée en aluminium.

Le module de puissance 30 est en contact thermique avec le dispositif de refroidissement 10.

Le module de puissance 30 comporte une pluralité de pattes de connexion électriques agencées pour la connexion électrique du module de puissance avec les composants électriques de puissance.

## Revendications

1. Equipement électrique de puissance (1), notamment pour véhicule automobile, cet équipement comportant :
- au moins deux composants électriques de puissance (2, 3), notamment connectés électriquement en parallèle,
- au moins deux conducteurs électriques (4, 5) chacun connectés à l'un des composants électriques de puissance, les deux conducteurs comportant chacun au moins une portion d'échange thermique (6, 7),
- un dispositif de refroidissement (10) agencé pour refroidir les conducteurs électriques via les portions d'échange thermique, équipement dans lequel les portions d'échange thermique des conducteurs sont coplanaires,
ledit équipement étant **caractérisé en ce que** :
- l'un au moins des conducteurs électriques, comporte, outre la portion d'échange thermique avec l'un des composants électrique de puissance, une portion de contact électrique (18 ;19) avec l'autre des composants électriques de puissance, cette portion de contact étant de préférence éloignée du dispositif de refroidissement,
- la portion de contact (18, 19) de l'un des conducteurs est sur un côté du composant électrique et la portion d'échange thermique (6, 7) de l'autre des conducteurs est sur un côté opposé de ce composant électrique, et
- l'un au moins des conducteurs comporte un bras (20) reliant la portion d'échange thermique à la portion de contact, ce bras étant de préférence sensiblement perpendiculaire à la portion d'échange thermique.

2. Equipement selon la revendication précédente, dans lequel les portions d'échange thermique des conducteurs sont en contact thermique, direct ou indirect, avec le dispositif de refroidissement.

3. Equipement selon l'une des revendications précédentes, dans lequel les portions d'échange thermique (6, 7) présentent au moins un bord droit, les bords droits des portions étant alignés.

4. Equipement selon l'une des revendications précédentes, dans lequel les portions d'échange thermique présentent une forme sensiblement rectangulaire.

5. Equipement selon l'une des revendications précédentes, dans lequel l'un au moins des conducteurs, de préférence les deux conducteurs, est connecté à un module de puissance via des pattes de connexion.

6. Equipement selon l'une des revendications précédentes, dans lequel les conducteurs sont réalisés par découpe et pliage d'une plaque, par exemple en aluminium.

7. Equipement selon l'une des revendications précédentes, dans lequel l'un au moins des composants électriques de puissance comporte au moins une unité de stockage d'énergie électrique (35), notamment un condensateur, notamment une pluralité d'unités, notamment de condensateurs.

8. Equipement selon l'une des revendications précédentes, dans lequel le dispositif de refroidissement comporte une paroi d'échange thermique (37) contre laquelle sont posées les portions d'échange thermique des conducteurs, cette paroi étant de préférence sensiblement plane.

9. Equipement selon la revendication précédente, dans lequel le dispositif de refroidissement comporte un canal de circulation (38) d'un fluide de refroidissement, par exemple de l'eau ou du glycol.

10. Equipement selon l'une des revendications précédentes, dans lequel l'équipement est agencé en module de puissance, par exemple onduleur.

11. Equipement selon la revendication précédente agencé en onduleur, dans lequel l'onduleur est agencé pour opérer à une puissance supérieure à 50 kW, notamment 100 kW, opérant notamment à une puissance électrique de 140 kW.

## Patentansprüche

1. Elektrische Leistungsausrüstung (1), insbesondere für ein Kraftfahrzeug, wobei diese Ausrüstung aufweist:
- mindestens zwei elektrische Leistungsbauteile (2, 3), insbesondere elektrisch parallel verbunden,
- mindestens zwei elektrische Leiter (4, 5), die je mit einem der elektrischen Leistungsbauteile verbunden sind, wobei die zwei Leiter je mindestens einen Wärmeaustauschabschnitt (6, 7) aufweisen,
- eine Kühlvorrichtung (10), die eingerichtet ist, um die elektrischen Leiter über die Wärmeaustauschabschnitte zu kühlen,
Ausrüstung, bei der die Wärmeaustauschabschnitte der Leiter koplanar sind,
wobei die Ausrüstung **dadurch gekennzeichnet ist, dass**:
- mindestens einer der elektrischen Leiter außer dem Wärmeaustauschabschnitt mit einem der elektrischen Leistungsbauteile einen elektrischen Kontaktabschnitt (18; 19) mit dem anderen der elektrischen Leistungsbauteile aufweist, wobei dieser Kontaktabschnitt vorzugsweise von der Kühlvorrichtung entfernt ist,
- der Kontaktabschnitt (18, 19) eines der Leiter sich auf einer Seite des elektrischen Bauteils befindet, und der Wärmeaustauschabschnitt (6, 7) des anderen der Leiter sich auf einer gegenüberliegenden Seite dieses elektrischen Bauteils befindet, und
- mindestens einer der Leiter einen Arm (20) aufweist, der den Wärmeaustauschabschnitt mit dem Kontaktabschnitt verbindet, wobei dieser Arm vorzugsweise im Wesentlichen lotrecht zum Wärmeaustauschabschnitt ist.

2. Ausrüstung nach dem vorhergehenden Anspruch, wobei die Wärmeaustauschabschnitte der Leiter in direktem oder indirektem Wärmekontakt mit der Kühlvorrichtung sind.

3. Ausrüstung nach einem der vorhergehenden Ansprüche, wobei die Wärmeaustauschabschnitte (6, 7) mindestens einen geraden Rand aufweisen, wobei die geraden Ränder der Abschnitte fluchtend ausgerichtet sind.

4. Ausrüstung nach einem der vorhergehenden Ansprüche, wobei die Wärmeaustauschabschnitte eine im Wesentlichen rechtwinklige Form aufweisen.

5. Ausrüstung nach einem der vorhergehenden Ansprüche, wobei mindestens einer der Leiter, vorzugsweise die beiden Leiter, über Verbindungslaschen mit einem Leistungsmodul verbunden ist.

6. Ausrüstung nach einem der vorhergehenden Ansprüche, wobei die Leiter durch Ausschneiden und Biegen einer Platte zum Beispiel aus Aluminium hergestellt werden.

7. Ausrüstung nach einem der vorhergehenden Ansprüche, wobei mindestens eines der elektrischen Leistungsbauteile mindestens eine Speichereinheit elektrischer Energie (35) aufweist, insbesondere einen Kondensator, insbesondere eine Vielzahl von Einheiten, insbesondere von Kondensatoren.

8. Ausrüstung nach einem der vorhergehenden Ansprüche, wobei die Kühlvorrichtung eine Wärmeaustauschwand (37) aufweist, gegen die die Wärmeaustauschabschnitte der Leiter angebracht sind, wobei diese Wand vorzugsweise im Wesentlichen eben ist.

9. Ausrüstung nach dem vorhergehenden Anspruch, wobei die Kühlvorrichtung einen Strömungskanal (38) eines Kühlmittels aufweist, zum Beispiel Wasser oder Glykol.

10. Ausrüstung nach einem der vorhergehenden Ansprüche, wobei die Ausrüstung als Leistungsmodul eingerichtet ist, zum Beispiel Wechselrichter.

11. Ausrüstung nach dem vorhergehenden Anspruch, die als Wechselrichter eingerichtet ist, wobei der Wechselrichter eingerichtet ist, um mit einer Leistung von mehr als 50 kW, insbesondere 100 kW, betrieben zu werden, insbesondere mit einer elektrischen Leistung von 140 kW betrieben wird.

## Claims

1. Power electrical apparatus (1), in particular for a motor vehicle, this apparatus comprising:
- at least two power electrical components (2, 3), in particular electrically connected in parallel,
- at least two electrical conductors (4, 5) each connected to one of the power electrical components, the two conductors each comprising at least one heat exchange portion (6, 7),
- a cooling device (10) arranged to cool the electrical conductors via the heat exchange portions, in which apparatus the heat exchange portions of the conductors are coplanar,
said apparatus being **characterized in that**:
- at least one of the electrical conductors comprises, in addition to the heat exchange portion for heat exchange with one of the power electrical components, an electrical contact portion (18; 19) for electrical contact with the other of the power electrical components, this contact portion preferably being located at a distance from the cooling device,
- the contact portion (18, 19) of one of the conductors is on one side of the electrical component and the heat exchange portion (6, 7) of the other of the conductors is on an opposite side of this electrical component, and
- at least one of the conductors comprises an arm (20) connecting the heat exchange portion to the contact portion, this arm preferably being substantially perpendicular to the heat exchange portion.

2. Apparatus according to the preceding claim, in which the heat exchange portions of the conductors are in direct or indirect thermal contact with the cooling device.

3. Apparatus according to one of the preceding claims, in which the heat exchange portions (6, 7) have at least one straight edge, the straight edges of the portions being aligned.

4. Apparatus according to one of the preceding claims, in which the heat exchange portions are substantially rectangular in shape.

5. Apparatus according to one of the preceding claims, in which at least one of the conductors, preferably both conductors, is/are connected to a power module via connection lugs.

6. Apparatus according to one of the preceding claims, in which the conductors are produced by cutting and folding a plate, for example made of aluminium.

7. Apparatus according to one of the preceding claims, in which at least one of the power electrical components comprises at least one electrical energy storage unit (35), in particular a capacitor, in particular a plurality of units, in particular capacitors.

8. Apparatus according to one of the preceding claims, in which the cooling device comprises a heat exchange wall (37) against which the heat exchange portions of the conductors are placed, this wall preferably being substantially planar.

9. Apparatus according to the preceding claim, in which the cooling device comprises a flow channel (38) for a coolant fluid, for example water or glycol.

10. Apparatus according to one of the preceding claims, in which the apparatus is arranged as a power module, for example an inverter.

11. Apparatus according to the preceding claim arranged as an inverter, in which the inverter is arranged to operate at a power higher than 50 kW, in particular 100 kW, operating in particular at an electrical power of 140 kW.
